# EUROPÄISCHE PATENTSCHRIFT

(11) **EP 1 117 852 B1**
(45) Veröffentlichungstag und Bekanntmachung des Hinweises auf die Patenterteilung: **31.07.2002**
(21) Anmeldenummer: 99968251.1
(22) Anmeldetag: 20.08.1999
(51) Int. Cl.: C23C 14/28, C23C 14/06

(54) **VERFAHREN UND VORRICHTUNG ZUR BESCHICHTUNG VON SUBSTRATEN IM VAKUUM**
METHOD AND DEVICE FOR COATING SUBSTRATES IN A VACUUM
PROCEDE ET DISPOSITIF POUR ENDUIRE DES SUBSTRATS SOUS VIDE

(30) Priorität: 26.08.1998 DE 19838824; 31.10.1998 DE 19850217
(43) Veröffentlichungstag der Anmeldung: 25.07.2001
(73) Patentinhaber: FRAUNHOFER-GESELLSCHAFT ZUR FÖRDERUNG DER ANGEWANDTEN FORSCHUNG E.V., 80636 München (DE)
(72) Erfinder: SCHEIBE, Hans-Joachim, D-01309 Dresden (DE); MEYER, Carl-Friedrich, D-01474 Pappritz (DE); SCHULTRICH, Bernd, D-01257 Dresden (DE); ZIEGELE, Holger, D-73547 Lorch (DE)
(74) Vertreter: Pfenning, Meinig & Partner GbR
(86) Internationale Anmeldenummer: EP9906129
(87) Internationale Veröffentlichungsnummer: WO0012775

(56) Entgegenhaltungen:
- EP-A1- 0 437 890
- DE-A1- 19 538 110
- US-A- 5 254 832
- US-A- 5 698 273

## Beschreibung

Die Erfindung betrifft ein Verfahren sowie eine Vorrichtung nach dem Oberbegriff des Anspruchs 1.

Bei den verschiedensten bekannten PVD-Verfahren, mit denen die verschiedensten Substrate mit verschiedensten Beschichtungen versehen werden können, ist es bekannt, bestimmte Schichteigenschaften durch die Zugabe verschiedener Gase bzw. Gasgemische zu beeinflussen. Dabei erfolgt die Zugabe solcher Gase bzw. Gasgemische in die Vakuumkammer mit einem entsprechend einstellbaren Gasdruck. Bei einer großen Anzahl solcher bekannten Verfahren wird gleichzeitig auch ein gewisser Anteil eines Gases wieder durch eine entsprechende Austrittsöffnung abgezogen.

Bei der Zuführung eines reaktiven Gases bzw. Gasgemisches können infolge ablaufender chemischer Reaktionen, die mit dem verdampften Targetmaterial und der jeweiligen Gaskomponente gebildeten Verbindungen als Schicht, wie z.B. eine Oxid- bzw. Nidridschicht abgeschieden werden. Dabei können die in der Vakuumkammer ablaufenden chemischen Reaktionen nur begrenzt beeinflußt werden und es können Inhomogenitäten, die die gewünschten Eigenschaften negativ beeinflussen, nicht generell ausgeschlossen werden.

Bei den verschiedensten PVD-Verfahren wird von einem Target ein Plasma erzeugt und die ionisierten Teilchen aus dem Plasma können eine Schicht auf der Oberfläche eines Substrates bilden. Die Erzeugung des Plasmas kann auf vielfältige Art und Weise erfolgen, wobei die erfindungsgemäße Lösung, besonders vorteilhaft auf solche PVD-Verfahren gerichtet sein soll, die die Erzeugung des Plasmas unter Verwendung eines Laserstrahls, der auf das Target gerichtet wird, durchgeführt werden. Dabei kann das Plasma allein mit Hilfe eines Laserstrahls, ausreichender Intensität oder in Verbindung mit einer Vakuum-Bogenentladung, die auch laserunterstützt gezündet wird, erfolgen. Solche bekannten Verfahren sind z.B. in US 4,987,007 für die alleinige Anwendung eines Laserstrahls und in DD 279 695 B5 als sogenanntes Laser-Arc-Verfahren bekannt.

Das Plasma kann aber auch ohne jegliche Laserunterstützung, allein mit einer bekannten Vakuum-Bogenentladung erzeugt werden.

Bei der Herstellung diamantähnlicher Kohlenstoffschichten können diese bekannten Verfahren ebenfalls Verwendung finden, wobei in diesem Falle nahezu reiner Kohlenstoff, in Form von Graphit als Targetmaterial verwendet wird.

Es hat sich als günstig erwiesen, ein Gas, bevorzugt ein Edelgas in das expandierende Plasma einzuspeisen, um z.B. Nanostrukturen in der Schicht auszubilden. Dadurch können die sogenannten Nanoröhren, üblicherweise Nanotubes bzw. Fullerene genannt, in einer solchen Schicht erhalten werden. Solche Strukturen können in Form von Pulvern, Faserbündeln in eine amorphe Schicht eingebaut sein.

Mit diesen bekannten Lösungen sind jedoch nur geringe Ausbeuten bzw. Beschichtungsraten sowie eine Beschichtung von relativ klein bemessenen Flächen erreichbar. Außerdem werden die gewünschten kristallinen Kohlenstoffstrukturen willkürlich mit geringer Konzentration in einer solchen Schicht eingebaut und es besteht keine Möglichkeit, gezielt Einfluß auf eine gewünschte Orientierung bzw. Texturierung zu nehmen.

Entscheidende Gründe für diese Nachteile bestehen darin, daß Gasen wegen des hohen Teilchendruckes im Plasma ein Eindringen in das Plasma weitestgehend nicht möglich ist.

Außerdem ist aus US 5,254,832 und EP 0 437 890 A1 ein Verfahren zum Herstellen von mehrkomponentigen Materialien bekannt, bei dem ein Substrat mit ultrafeinen Partikeln beschichtet werden soll. Die ultrafeinen Partikel werden zusammen mit einer weiteren Materialkomponente aufgebracht, wobei diese Komponente durch reaktive Abscheidung aus einer zusätzlichen Gasphase mittels eines reinen CVD- bzw. eines entsprechend modifizierten CVD-Verfahrens aufgebracht werden kann. Dabei wird auch ein inertes Transportgas verwendet, das in einer Alternative auf die Oberfläche des Targets und von dort in Richtung auf das Substrat und in einer zweiten Alternative durch ein mit einem Laser durchbohrtes Target und eine Öffnung einer Blende auf das Substrat gerichtet wird.

Es ist daher Aufgabe der Erfindung, ausgehend von bekannten Verfahren zur Beschichtung von Substraten im Vakuum, bei denen aus einem Target ein Plasma erzeugt wird, die Zuführung von Gasen bzw. Gasgemischen lokal und/oder zeitlich definiert zu ermöglichen.

Erfindungsgemäß wird diese Aufgabe mit den Merkmalen der Ansprüche 1 und 4 für Verfahren und den Merkmalen des Anspruchs 13 für eine Vorrichtung zur Durchführung eines solchen Verfahrens gelöst. Vorteilhafte Ausgestaltungsformen und Weiterbildungen der Erfindung, ergeben sich, bei Verwendung der in den untergeordneten Ansprüchen enthaltenen Merkmale. Gemäß der Erfindung soll dabei, ausgehend von den in DE 39 01 401 Cl, DD 279 695 B5, DD 280 338 B5 und US 4,987,007 beschriebenen Verfahren, auf deren Offenbarungsgehalt für die Erfindung jeweils voll inhaltlich Bezug genommen werden soll, dahingehend ergänzt werden, daß zumindest eines der dabei verwendeten Targets ein gewisses Maß an Porosität aufweist, das geeignet ist, eine Zwischenspeicherfunktion für ein Gas bzw. Gasgemisch in ausreichender Menge zu erfüllen sowie allein oder in Kombination mit der Zwischenspeicherfunktion geeignet ist, das Gas durch die Poren dem Plasma zeitlich und/oder örtlich definiert zuzuführen.

Dabei ist es vorteilhaft, wenn das Plasma, unabhängig ob allein mittels Laserstrahl oder in der kombinierten Verwendung von Laserstrahl und Vakuum-Bogenentladung erzeugt wird, einen gepulsten Laserstrahl zu verwenden, wobei eine entsprechende Auswahl einer geeigneten Laserlichtquelle für die verschiedenen möglichen Targetmaterialien erfolgen kann, um eine hohe Effizienz zu erreichen.

Bei dem Laser-Arc-Verfahren sollte das Target aus einem elektrisch leitenden Material, wie z.B. C, Al, Cu, Fe, Si, Ti, anderem Metall, Legierungen oder chemischen Verbindungen bestehen. Es können aber auch andere Elemente oder deren Verbindungen, beispielsweise B oder Ge verwendet werden. Um die erforderliche Porosität zu sichern, können hierfür günstigerweise Sinterkörper und/oder faserverstärkte Verbunde verwendet werden.

Wird das Plasma allein mittels Laserstrahl erzeugt, können auch Targets aus elektrisch nicht leitenden Materialien, wie z.B. verschiedenste Oxide, Nidride und Carbide Verwendung finden.

Wie bereits erwähnt, kann ein erfindungsgemäß ausgebildetes und zu verwendendes Target als Zwischenspeicher für die verschiedenen zu verwendenden Gase bzw. Gasgemische dienen. In diesem Fall wird vor dem eigentlichen Einleiten der Beschichtung eine Infiltration des Targets mit dem jeweiligen Gas bzw. Gasgemisch, bevorzugt bis an dessen Sättigungsgrenze durchgeführt und im Nachgang hierzu der eigentliche Beschichtungsvorgang eingeleitet.

Das jeweilige Gas bzw. Gasgemisch kann aber auch über Hohlräume, die innerhalb des Targets ausgebildet sind bzw. über eine bevorzugt rohrförmige Gaszuführung durch die Poren während der Beschichtung zu- bzw. bei nicht ausreichender Speicherkapazität eines Targets nachgeführt werden. Dabei sollte jedoch so verfahren werden, daß die infolge Gasverbrauch geleerten Poren des Targets wieder gefüllt werden, so daß die Zwischenspeicherfunktion des Targets beibehalten wird.

Als Gas können beispielsweise Edelgase (z.B. die Gase der VIII. Hauptgruppe), O₂, N₂, H₂ oder Kohlenwasserstoffverbindungen oder Gasgemische davon aber auch andere Gase und Gasgemische verwendet werden.

In einer solchen Gaszuführung können bevorzugt Durchbrechungen ausgebildet sein, durch die bei einem konstanten Gasdruck eine dosierte Gaszuführung zum Plasma infolge der Drosselwirkung der Durchbrechungen erreicht werden kann. Daraus resultiert ein weiterer Vorteil dadurch, daß das jeweilige Gas bzw. Gasgemisch über einen Kreislauf geführt werden kann, bei dem ein Bestandteil die Gaszuführung ist und das Target durch das Gas, das in einem Überschuß im Kreislauf geführt wird, gekühlt wird.

Mit der erfindungsgemäßen Lösung lassen sich, besonders vorteilhaft diamantähnliche Kohlenstoffbeschichtungen herstellen, in denen kristalline Nanostrukturen, homogen verteilt, ausgebildet sind. Dabei wirkt sich insbesondere die Möglichkeit, der sowohl zeitlich, wie auch lokal definierten Zuführung von Gas, bei der Plasmaerzeugung günstig aus.

Außerdem kann eine koordinierte Bewegung des Substrates (translatorisch, rotatorisches Verschwenken/Drehen um eine Achse oder einen Punkt) in bezug zum Plasma zu einer gezielten Texturbildung, d.h. einer gewünschten Ausrichtung der Nano-Kristalle führen.

Die erfinderisch zu verwendenden Targets sollten eine Porosität von mindestens 3 %, bevorzugt mehr als 5 % aufweisen, um die gewünschten Eigenschaften zu erfüllen.

Soll beispielsweise ein Mehrschichtaufbau verschiedener Schichten ausgebildet werden, können mindestens zwei verschiedene geeignete Targetmaterialien verwendet werden. Dabei können sie getrennt voneinander angeordnet werden, wobei zumindest eines der verschiedenen Targets erfindungsgemäß modifiziert ist. Es können auch verschiedene Gase bzw. Gasgemische über bzw. aus diesen Targets zugeführt werden.

Die verschiedenen Targetmaterialien können dabei auch unmittelbar benachbart angeordnet sein, wie dies z.B. als Teilscheiben eines walzenförmigen Targets der Fall sein kann. Im letzt genannten Fall können die einzelnen Teilscheiben mit getrennten Gaszuführungen und ggf. Abführungen verbunden sein.

Nachfolgend soll die Erfindung beispielhaft beschrieben werden.

Dabei zeigt:
- Figur 1: den schematischen Aufbau einer erfindungsgemäßen Vorrichtung, bei der Plasma von einem Target mit dem Laser-Arc-Verfahren erzeugt wird und
- Figur 2: den schematischen Aufbau eines Beispiels einer Vorrichtung, bei der Plasma von einem Target mit einem gepulsten Laserstrahl erzeugt wird.

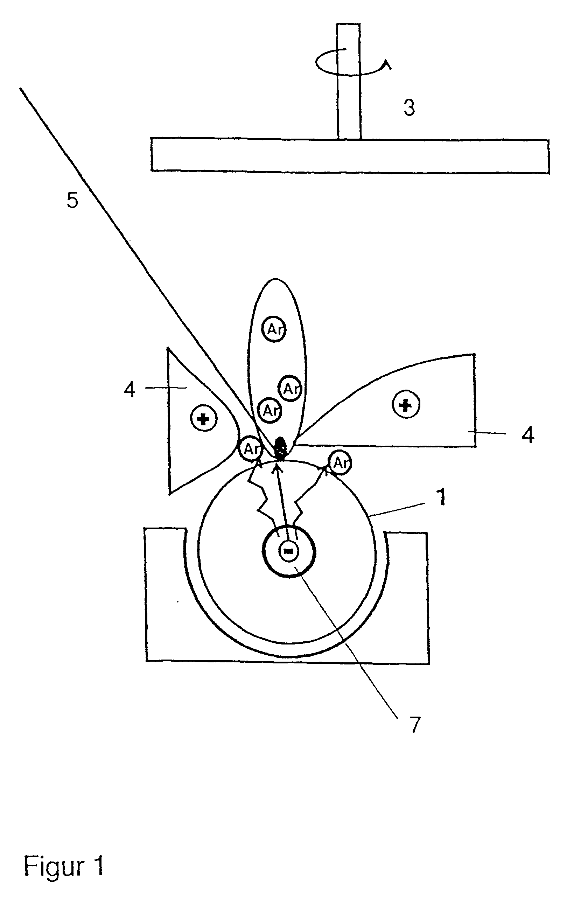

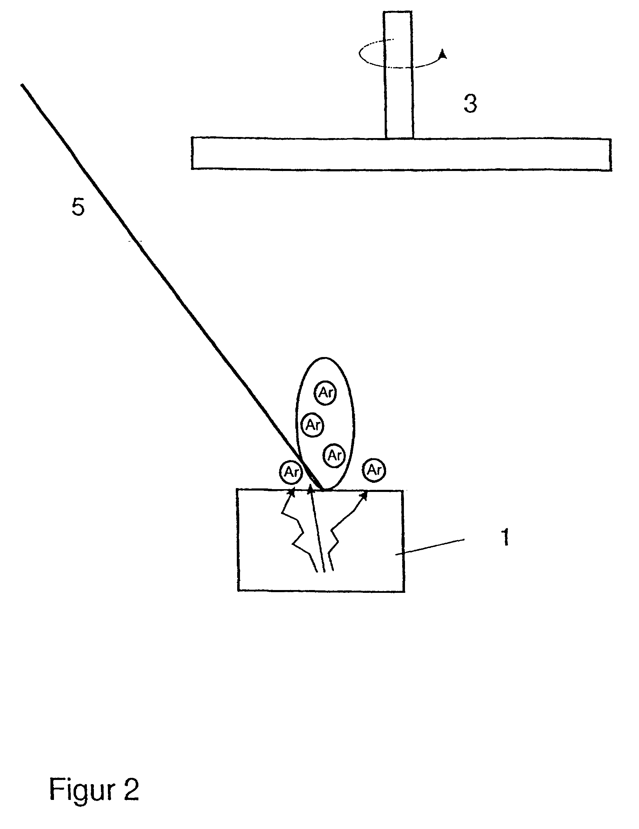

Bei den in den Figuren 1 und 2 gezeigten Vorrichtungen, wurde sämtlichst auf die Darstellung der Vakuumkammer, in der die in den Figuren dargestellten einzelnen Komponenten aufgenommen sind, verzichtet, da davon ausgegangen werden kann, daß dies für den einschlägigen Fachmann auf der Hand liegt.

Bei dem in der Figur 1 gezeigten Beispiel einer erfindungsgemäßen Vorrichtung, wird ein walzenförmiges Target 1 verwendet, das um seine Längsachse gleichförmig gedreht wird. Für die Erzeugung eines Plasmas aus einer Bogenentladung wird eine Anode 4 verwendet, die in bevorzugter Form als Anodenschirm mit einem zentralen Spalt, durch den das erzeugte Plasma austreten kann, ausgebildet ist, wie dies mit der in Figur 1 dargestellten Form der Anode 4 angedeutet ist. Zur Zündung der Vakuum-Bogenentladung wird ein Laserstrahl 5 in gepulster Form auf die Manteloberfläche des Targets 1 gerichtet und gleichzeitig die Anodenspannung ensprechend erhöht, so daß eine Bogenentladung zwischen Target 1 und Anode 4 gezündet und im Anschluß an die Verdampfung von Targetmaterial ein Plasma erzeugt werden kann, das durch den Anodenspalt in Richtung auf das Substrat 3 gelangt.

Bei diesem Beispiel kann am Substrat 3 ein elektrisch negatives Potential angelegt sein, was für bestimmte Zwecke (Beschleunigung der Ionen) günstig sein kann. Es ist aber nicht generell erforderlich, das Substrat auf ein elektrisch negatives Potential zu legen, sondern es kann ohne weiteres auch ein Anschluß an die Masse der Vorrichtung ausreichend sein.

Mit diesem Verfahren bzw. einer solchen Vorrichtung können relativ großformatige Substrate 3 beschichtet werden, wobei entsprechend lange walzenförmige Targets 1 verwendet werden können. Eine Begrenzung der Größe der zu beschichtenden Fläche kann lediglich durch Grenzen der Strahlformungseinheit des Laserstrahls 5 auftreten, wobei ggf. aber auch zwei und mehr als zwei Laserstrahlen parallel verwendet werden können.

In der Figur 1 ist außerdem eine rohrförmige Gaszuführung 7 durch das Innere des walzenförmigen Targets 1 dargestellt, durch die das jeweilig verwendete Gas bzw. Gasgemisch über die gesamte Länge durch das walzenförmige Target 1 geführt werden kann. Die rohrförmige Gaszuführung 7 kann beispielsweise aus einem relativ mechanisch festen Metall sein, in dessen Mantelfläche Durchbrechungen in regelmäßigen Abständen und regelmäßig über den Umfang verteilt ausgebildet sind, durch die das Gas bzw. Gasgemisch in das poröse Material des walzenförmigen Targets 1 eindringen und bis an die Oberfläche, d.h. die äußere Mantelfläche des walzenförmigen Targets 1 und von dort unmittelbar in das Plasma gelangen kann. An den beiden Stirnseiten der rohrförmigen Gaszuführung 7 können, nicht dargestellte Anschlüsse für eine Gaszu- und Abführung vorhanden sein, über die das verwendete Gas bzw. Gasgemisch gegebenenfalls unter Einbeziehung eines Wärmetauschers im Kreislauf geführt werden kann, um gleichzeitig eine Kühlung des walzenförmigen Targets 1 zu erreichen.

Bei dem in der Figur 2 gezeigten Beispiel einer erfindungsgemäßen Vorrichtung, werden wieder die gleichen einzelnen Komponenten verwendet, wie dies auch bei dem Beispiel nach Figur 1 der Fall ist und lediglich das Plasma allein mittels Laserstrahl 5 erzeugt wird.

Es wird ein herkömmlich geformtes aber poröses Target 1 verwendet, bei dem in diesem Fall ein negatives Potential angelegt ist, wobei hierauf aber auch verzichtet werden kann. Auf das Target 1 wird ein bevorzugt gepulster Laserstrahl 5 gerichtet und das Plasma allein mit dessen Energie aus dem Targetmaterial erzeugt. Das Target 1 kann aus elektrisch nicht aber auch aus elektrisch leitendem Material bestehen, je nachdem welche Schicht auf dem Substrat 3 ausgebildet werden soll.

Das in der Figur 2 dargestellte planare Target 1 kann, wie im allgemeinen Teil der Beschreibung der erfindungsgemäßen Lösung, allein durch Nutzung der Speicherkapazität im Target 1 erfindungsgemäß verwendet werden, es besteht aber auch die Möglichkeit, in hier nicht dargestellter Form, einmal in dessen Inneren Hohlräume auszubilden, in die Gas bzw. Gasgemisch eingeführt werden kann oder zum anderen, ebenfalls nicht dargestellt, unterhalb des planaren Targets 1 einen kastenförmigen Hohlraum anzuordnen, in den Gas bzw. Gasgemisch zumindest eingeführt werden kann. Im letztgenannten Fall kann die Gasdosierung durch Einstellung des Druckes im Hohlraum unter Berücksichtigung der Porosität des Targetmaterials erfolgen.

Bei einer Vorrichtung, wie sie mit dem Beispiel gemäß Figur 1 beschrieben worden und die in Verbindung mit dem bekannten Laser-Arc-Verfahren betrieben werden kann, können verschiedenste Schichten auf verschiedensten Substraten aufgebracht werden. So können Aluminium, verschiedene Aluminiumverbindungen (durch Zugabe entsprechend reaktiver Gase) und auch diamantähnliche Kohlenstoffschichten aufgebracht werden.

Die Ausbildung einer diamantähnlichen Kohlenstoffschicht ist in den Figuren 1 und 2 dargestellt. Dabei wurde Argon, als Edelgas über das Target 1 zugeführt und es ist weiter erkennbar, wie der ionisierte Kohlenstoff in den zwei für diamantähnlichen Kohlenstoff typischen SP2- und SP3-Phasen auf der Oberfläche des Substrates 3, das hier jeweils um eine Achse, zur Ausbildung einer Textur, gedreht, abgeschieden wird. Die Elektronen aus dem Plasma sollen bevorzugt vom Substrat, also der sich ausbildenden Schicht fern gehalten werden.

Insbesondere für die Herstellung diamantähnlicher Kohlenstoffschichten, haben sich Targets mit folgenden Eigenschaften als besonders günstig herausgestellt:

| | |
|---|---|
| Dichte | 1,88 g/cm³ |
| Porosität | 10 Vol % nach DIN 66133 |
| Porengröße | 0,6 µm nach DIN 66133 |
| spez. elektrischer Widerstand | 13 µ Ohmmeter |

## Patentansprüche

1. Verfahren zur Beschichtung von Substraten im Vakuum, bei dem aus einem Target unter Verwendung eines Laserstrahls ein Plasma erzeugt und ionisierte Teilchen des Plasmas auf dem Substrat als Schicht abgeschieden werden, wobei inertes und/oder reaktives Gas oder ein Gasgemisch zugeführt wird,
**dadurch gekennzeichnet, daß** das Gas bzw. Gasgemisch aus und/oder durch das durch Porosität eine Zwischenspeicherfunktion für das Gas bzw. Gasgemisch aufweisende Target (1) dem Plasma zugeführt wird.

2. Verfahren nach Anspruch 1,
**dadurch gekennzeichnet, daß** das Plasma mit einem gepulsten Laserstrahl (5) erzeugt wird.

3. Verfahren nach Anspruch 1 oder 2,
**dadurch gekennzeichnet, daß** das Plasma mit einer mittels eines gepulsten Laserstrahls (5) gezündeten Vakuum-Bogenentladung erzeugt wird.

4. Verfahren zur Beschichtung von Substraten im Vakuum, bei dem aus einem Target mittels einer Vakuum-Bogenentladung ein Plasma erzeugt und ionisierte Teilchen des Plasmas auf dem Substrat als Schicht abgeschieden werden, wobei inertes und/oder reaktives Gas oder ein Gasgemisch zugeführt wird,
**dadurch gekennzeichnet, daß** das Gas bzw. Gasgemisch aus und/oder durch das durch Porosität eine Zwischenspeicherfunktion für das Gas bzw. Gasgemisch aufweisende Target (1) dem Plasma zugeführt wird.

5. Verfahren nach einem der Ansprüche 1 bis 4,
**dadurch gekennzeichnet, daß** ein Target (1) aus einem elektrisch leitenden Material verwendet wird.

6. Verfahren nach einem der Ansprüche 1 bis 5,
**dadurch gekennzeichnet, daß** das Gas oder Gasgemisch vor der Beschichtung in das poröse Target (1) infiltriert und dort bis zur Beschichtung gespeichert wird.

7. Verfahren nach einem der Ansprüche 1 bis 5,
**dadurch gekennzeichnet, daß** das Gas oder Gasgemisch über Hohlräume innerhalb des Targets (1) durch die Poren des Targets (1) während der Beschichtung kontinuierlich zu- oder nachgeführt wird.

8. Verfahren nach einem der Ansprüche 1 bis 7,
**dadurch gekennzeichnet, daß** das Gas oder Gasgemisch in einem Kreislauf durch die Hohlräume oder eine rohrförmige Gaszuführung (7) im Überschuß geführt wird.

9. Verfahren nach einem der Ansprüche 1 bis 8,
**dadurch gekennzeichnet, daß** ein Target (1) aus C, Si, B, Ge oder einem Metall oder einer Legierung oder einer Verbindung dieser Elemente verwendet wird.

10. Verfahren nach einem der Ansprüche 1 bis 9,
**dadurch gekennzeichnet, daß** als Gas ein Edelgas, O₂, N₂, H₂ oder eine Kohlenwasserstoffverbindung oder ein Gasgemisch verwendet wird.

11. Verfahren nach einem der Ansprüche 1 bis 10,
**dadurch gekennzeichnet, daß** das Substrat (3) während der Beschichtung translatorisch und/oder rotatorisch bewegt und/oder um einen Punkt oder eine Achse verschwenkt wird.

12. Verfahren nach einem der Ansprüche 1 bis 11,
**dadurch gekennzeichnet, daß** mit einem Kohlenstoff-Target (1) diamantähnliche Kohlenstoff-Beschichtungen hergestellt werden.

13. Vorrichtung zur Durchführung des Verfahrens nach einem der Ansprüche 1 bis 12,
**dadurch gekennzeichnet, daß** das Target (1) aus einem porösen Material besteht, dessen Porosität die Funktion(en) einer Speicherung eines Gases oder Gasgemisches in den Poren und/oder der Zufuhr des Gases oder Gasgemisches durch die Poren in das Plasma erfüllt.

14. Vorrichtung nach Anspruch 13,
daß das Target (1) ein Sinterkörper ist.

15. Vorrichtung nach Anspruch 13 oder 14,
**dadurch gekennzeichnet, daß** das Target (1) eine Porosität von mindestens 3 % aufweist.

16. Vorrichtung nach einem der Ansprüche 13 bis 15,
**dadurch gekennzeichnet, daß** das Target (1) drehbar und walzenförmig ausgebildet ist.

17. Vorrichtung nach einem der Ansprüche 13 bis 16,
**dadurch gekennzeichnet, daß** im Inneren des Targets (1) ein Hohlraum als Gaszuführung oder Gasspeicher ausgebildet ist.

18. Vorrichtung nach einem der Ansprüche 13 bis 17,
**dadurch gekennzeichnet, daß** im Inneren des Targets (1) eine rohrförmige Gaszuführung (7) vorhanden ist, deren Mantelfläche Durchbrechungen zur Gasdosierung aufweist.

19. Vorrichtung nach einem der Ansprüche 13 bis 18,
**dadurch gekennzeichnet, daß** neben dem als Kathode geschalteten Target (1) eine Anode (4), zwischen denen eine Bogenentladung mittels des Laserstrahls (5) gezündet wird, vorhanden ist.

## Claims

1. A method for coating substrates inin a vacuum, in which a plasma is generated from a target using a laser beam and ionized particles of the plasma are deposited on the substrate in the form of a layer, inert and/or reactive gas or a gas mixture being supplied, **characterized in that** the gas or gas mixture is supplied to the plasma from and/or through the target (1), which has a temporary storage function for the gas or gas mixture on account of its porosity.

2. The method as claimed in claimed 1, **characterized in that** the plasma is generated using a pulsed laser beam (5).

3. The method as claimed in claim 1 or 2, **characterized in that** the plasma is generated using a vacuum arc discharge which is ignited by means of a pulsed laser beam (5).

4. A method for coating substrates inin a vacuum, in which a plasma is generated from a target by means of a vacuum arc discharge and ionized particles of the plasma are deposited on the substrate in the form of a layer, inert and/or reactive gas or a gas mixture being supplied, **characterized in that** the gas or gas mixture is supplied to the plasma from and/or through the target (1), which has a temporary storage function for the gas or gas mixture on account of its porosity.

5. The method as claimed in one of claims 1 to 4, **characterized in that** a target (1) made from an electrically conductive material is used.

6. The method as claimed in one of claims 1 to 5, **characterized in that** the gas or gas mixture, prior to the coating, infiltrates into the porous target (1), where it is stored until the coating takes place.

7. The method as claimed in one of claims 1 to 5, **characterized in that** the gas or gas mixture, via cavities inside the target (1), is continuously supplied or added during the coating, through the pores of the target (1).

8. The method as claimed in one of claims 1 to 7, **characterized in that** the gas or gas mixture is passed in excess in a circuit through the cavities or a tubular gas supply (7).

9. The method as claimed in one of claims 1 to 8, **characterized in that** a target (1) made from C, Si, B, Ge or a metal or an alloy or a compound of these elements is used.

10. The method as claimed in one of claims 1 to 9, **characterized in that** the gas used is an inert gas, O₂, N₂, H₂ or a hydrocarbon compound or a gas mixture.

11. The method as claimed in one of claims 1 to 10, **characterized in that** the substrate (3), during the coating, is moved in translation and/or rotation and/or is pivoted about a point or an axis.

12. The method as claimed in one of claims 1 to 11, **characterized in that** diamond-like carbon coatings are produzed using a carbon target (1).

13. A device for carrying out the method as claimed in one of claims 1 to 12, **characterized in that** the target (1) consists of a porous material, the porosity of which fulfills the function(s) of storing a gas or gas mixture in the pores and/or supplying the gas or gas mixture to the plasma through the pores.

14. The device as claimed in claim 13, in that the targes (1) is a sintered body.

15. The device as claimed in claim 13 or 14, **characterized in that** the target (1) has a porosity of at least 3%.

16. The device as claimed in one of claims 13 to 15, **characterized in that** the target (1) is rotatable and is designed in the form of a roller.

17. The device as claimed in one of claims 13 to 16, **characterized in that** a cavity is formed as gas supply or gas store in the interior of the target (1).

18. The device as claimed in one of claims 13 to 17, **characterized in that** a tubular gas supply (7), the circumferential surface of which has apertures for gas metering, is present in the interior of the target (1).

19. The device as claimed in one of claims 13 to 18, **characterized in that**, in addition to the target (1) which is connected as cathode, there is an anode (4), an arc discharge being ignited between them by means of the laser beam (5).

## Revendications

1. Procédé pour enduire des substrats sous vide dans lequel on produit un plasma à partir d'une cible par utilisation d'un rayon laser et on dépose en couche des particules ionisées du plasma sur le substrat, et un gaz ou un mélange gazeux inerte et /ou réactif est introduit, **caractérisé en ce que** le gaz ou le mélange gazeux est introduit par porosité jusqu'au plasma à partir de et/ou à travers la cible (1) qui possède une fonction de stockage intermédiaire pour le gaz ou le mélange gazeux.

2. Procédé selon la revendication 1 **caractérisé en ce que** le plasma est produit par un rayon laser pulsé (5).

3. Procédé selon la revendication 1 ou 2 **caractérisé en ce que** le plasma est produit par décharge en arc sous vide amorcé au moyen d'un rayon laser pulsé (5).

4. Procédé pour l'enduction de substrats sous vide, dans lequel on produit un plasma à partir d'une cible au moyen d'une décharge en arc sous vide et on dépose des particules ionisées du plasma en couche sur le substrat, et on introduit un gaz ou un mélange gazeux inerte et/ou réactif, **caractérisé en ce que** le gaz ou le mélange gazeux est introduit par porosité jusqu'au plasma à partir de et/ou à travers la cible (1) qui possède une fonction de stockage intermédiaire.

5. Procédé selon l'une des revendications 1 à 4 **caractérisé en ce qu'**on utilise une cible (1) en un matériau électriquement conducteur.

6. Procédé selon l'une des revendications 1 à 5 **caractérisé en ce que**, avant l'enduction, le gaz ou le mélange gazeux est infiltré dans la cible poreuse (1) et y est stocké jusqu'à l'enduction.

7. Procédé selon l'une des revendications 1 à 5 **caractérisé en ce** le gaz ou le mélange gazeux est introduit ou évacué continuellement pendant l'enduction par des cavités à I l'intérieur de la cible (1) par les pores de la cible (1).

8. Procédé selon l'une des revendications 1 à 7 **caractérisé en ce** le gaz ou le mélange de gaz en excédent est guidé en un mouvement circulaire par les cavités ou par une conduite de gaz tubulaire (7).

9. Procédé selon l'une des revendications 1 à 8 **caractérisé en ce qu'**on utilise une cible (1) en C, Si, B, Ge ou en un métal ou en un alliage métallique ou en une combinaison de ces éléments.

10. Procédé selon l'une des revendications 1 à 9 **caractérisé en ce que** le gaz est un gaz rare, O², N², H² ou un hydrocarbure ou un mélange gazeux.

11. Procédé selon l'une des revendications 1 à 10 **caractérisé en ce que** le substrat (3) est déplacé pendant l'enduction en translation et/ou en rotation et/ou est basculé autour d'un point ou d'un axe.

12. Procédé selon ,l'une des revendications 1 à 11 **caractérisé en ce qu'**on réalise des enductions de carbone similaires à des diamants avec une cible (1) en carbone.

13. Dispositif pour la mise en oeuvre du procédé selon l'une des revendications 1 à 12 **caractérisé en ce que** la cible (1) est constituée en un matériau poreux, dont la porosité remplit la (les) fonction(s) d'un stockage d'un gaz ou d'un mélange gazeux dans les pores et/ou d'amenée du gaz ou du mélange gazeux par les pores dans le plasma.

14. Dispositif selon le revendication 13 **caractérisé en ce que** la cible (1) est un corps fritté.

15. Dispositif selon la revendication 13 ou 14 **caractérisé en ce que** la cible (1) présente une porosité d'au moins 3%.

16. Dispositif selon l'une des revendications 13 à 15 **caractérisé en ce que** la cible (1) est rotative et conformée en cylindre.

17. Dispositif selon l'une des revendications 13 à 16 **caractérisé en ce qu'**une cavité est agencée à l'intérieur de la cible (1) comme conduite d'amenée de gaz ou comme stockage de gaz.

18. Dispositif selon l'une des revendications 13 à 17 **caractérisé en ce qu'**à l'intérieur de la cible (1) est agencée une conduite tubulaire (7) d'amenée du gaz, dont la surface latérale comporte des perçages pour le dosage du gaz.

19. Dispositif selon l'une des revendications 13 à 18 **caractérisé en ce que** près de la cible (1) connectée en cathode il est prévu une anode (4), entre lesquelles une décharge en arc est amorcée au moyen du rayon laser (5).
